(19) Europäisches Patentamt
European Patent Office
Office européen des brevets

(11) **EP 3 949 042 B1**

(12) **FASCICULE DE BREVET EUROPEEN**

(45) Date de publication et mention
de la délivrance du brevet:
**01.03.2023 Bulletin 2023/09**

(21) Numéro de dépôt: **20719663.5**

(22) Date de dépôt: **24.04.2020**

(51) Classification Internationale des Brevets (IPC):
*H01S 5/02* (2006.01)   *H01S 5/022* (2006.01)
*H01S 5/026* (2006.01)   *H01S 5/10* (2006.01)
*H01S 5/12* (2006.01)   *H01S 5/125* (2006.01)
*H01S 5/14* (2006.01)   *H01S 5/20* (2006.01)

(52) Classification Coopérative des Brevets (CPC):
**H01S 5/021; H01S 5/022; H01S 5/026;
H01S 5/1014; H01S 5/1032; H01S 5/12;
H01S 5/125; H01S 5/141; H01S 5/2031**

(86) Numéro de dépôt international:
**PCT/EP2020/061501**

(87) Numéro de publication internationale:
**WO 2020/224994 (12.11.2020 Gazette 2020/46)**

(54) **LASER MONOMODE HYBRIDE III-V SUR SILICIUM DE FABRICATION SIMPLIFIÉE**

EINMODEN-HYBRID-III-V-AUF-SILIZIUM-LASER MIT VEREINFACHTEM AUFBAU

SINGLE-MODE HYBRID III-V ON SILICON LASER OF SIMPLIFIED CONSTRUCTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.05.2019 FR 1904842**

(43) Date de publication de la demande:
**09.02.2022 Bulletin 2022/06**

(73) Titulaire: **Commissariat à l'énergie atomique
et aux énergies alternatives**
**75015 Paris (FR)**

(72) Inventeurs:
• **MENEZO, Sylvie**
 **38054 GRENOBLE Cedex 09 (FR)**
• **POON, Joyce**
 **TORONTO, ONTARIO M4Y 2X6 (CA)**
• **THIESSEN, Torrey**
 **TORONTO, ONTARIO M5S 2P3 (CA)**

(74) Mandataire: **Brevalex**
 **Tour Trinity**
 **1 Bis Esplanade de La Défense**
 **CS 60347**
 **92035 Paris La Défense Cedex (FR)**

(56) Documents cités:
 **EP-A1- 2 811 593    EP-A1- 3 168 946**
 **FR-A1- 3 061 961**

## Description

## DOMAINE TECHNIQUE

Le domaine de l'invention est celui des composants photoniques intégrés qui utilisent à la fois les propriétés des matériaux semi-conducteurs aptes à émettre de la lumière et celles des matériaux semi-conducteurs utilisés classiquement dans les circuits intégrés.

L'invention concerne plus particulièrement un laser hybride sur silicium qui comprend un milieu amplificateur à hétérostructure III-V.

## TECHNIQUE ANTÉRIEURE

Un laser hybride III-V sur silicium comprend généralement :

- une structure à gain qui comporte au moins un milieu amplificateur optique à hétérostructure de type III-V, l'hétérostructure étant apte à émettre de la lumière et agencée de manière à être sus-jacente à une section d'un guide d'onde silicium pour former avec celui-ci une section de guide d'onde hybride,
- une structure de rétroaction optique permettant de former une cavité résonante pour le milieu amplificateur, et
- des transitions optiques entre la section de guide d'onde hybride et d'autres sections du guide d'onde silicium, notamment une section de propagation de la lumière émise par le laser.

Par hétérostructure de type III- V, on entend l'utilisation de matériaux pouvant être choisis dans la liste non exhaustive suivante : InP, GaAs, InGaAlAs, InGaAsP, AlGaAs, InAsP. L'hétérostructure d'un tel milieu amplificateur, aussi appelé milieu à gain, peut comporter un empilement de diverses couches, comme par exemple un empilement de couches formant des puits quantiques pris en sandwich entre une première couche dopée, de préférence dopée N, et une seconde couche dopée, de préférence dopée P.

Dans le cas d'un laser dit laser à rétroaction répartie (ou « Distributed Feedback Laser » en anglais - connu sous l'acronyme laser DFB), la structure de rétroaction optique est constituée par un réflecteur distribué, tel qu'un réseau de Bragg, sous ou dans la structure à gain, formant un miroir sélectif en longueur d'onde. Dans le cas d'un laser dit à réseau de Bragg distribué (ou « Distributed Bragg Reflector Laser » en anglais - connu sous l'acronyme laser DBR), la structure de rétroaction optique est constituée de réflecteurs disposés dans le guide d'onde, de part et d'autre de la section de guide d'onde hybride.

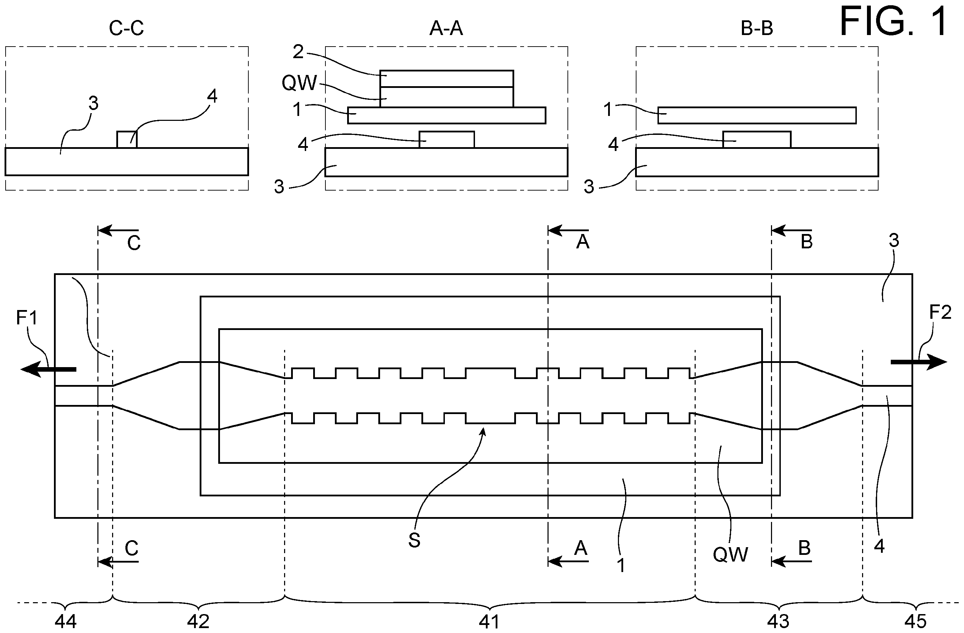

On a représenté sur la figure 1 une vue de dessus simplifiée d'un laser DFB, cette vue de dessus étant accompagnée de trois coupes prises transversalement au sens de propagation de la lumière qui illustrent différentes régions du laser.

Le laser DFB comprend un milieu amplificateur à hétérostructure III-V formé par exemple d'un empilement QW de puits quantiques pris en sandwich entre une couche d'InP dopée N 1 et une couche d'InP dopée P 2. L'épaisseur du sandwich constitué par les couches 1 et 2 et l'empilement de puits quantiques QW est typiquement comprise entre 2 et 3 $\mu$m. Le laser comprend un guide d'onde optique en silicium. Il s'agit par exemple d'un guide d'onde en arête (« rib waveguide » en anglais) qui comprend un guide d'onde en ruban 3 (« slab waveguide » en anglais) surmontée d'une arête ou nervure 4 (« rib » en anglais). Le guide d'onde comprend une section de couplage 41 en regard d'une portion centrale du milieu amplificateur, deux sections de transition 42, 43 agencées de part et d'autre de la section de couplage 41 et deux sections de propagation 44, 45, chacune optiquement couplée à l'une des sections de transition 42, 43. Les sections de transition 42, 43 sont dimensionnées pour ne quasiment présenter aucune perte de transmission et aucune réflectivité entre la section de couplage 41 et la section de propagation correspondante 44, 45. Comme connu de l'état de l'art, le guide d'onde en arête 3, 4 est pour cela épais (l'épaisseur cumulée du ruban 3 et de l'arête 4 est ainsi typiquement supérieure ou égale à 400 nm, voire à 500 nm) et les sections de transition 42, 43 sont plus larges que les sections de propagation 44, 45 (typiquement 400 nm de large pour une épaisseur de 500 nm). Un réseau de Bragg est formé dans la section de couplage 41 pour fournir la rétroaction optique. La lumière issue de la cavité laser est ainsi couplée avec le guide en silicium et se propage en sortie selon les flèches F1 et F2 depuis chacune des sections de propagation 44, 45.

Le réseau de Bragg est typiquement formé par gravure de structures quart d'onde du premier ordre $\frac{\lambda_{m0}}{4.n_{eff}}$ réalisées dans l'arête 4 à une période $\frac{\lambda_{m0}}{2.n_{eff}}$ où $\lambda_{m0}$ est la longueur d'onde dans le vide, et $n_{eff}$ est l'indice effectif du guide hybride (section AA). Le réseau de Bragg peut être conçu pour assurer un fonctionnement monomode du dispositif laser en venant introduire au centre de la section de couplage un segment S faisant office de saut de phase de type quart d'onde. Pour une longueur d'onde $\lambda_{m0}$ dans le vide de 1310 nm et un indice $n_{eff}$ standard d'environ 3,25, la période du réseau de Bragg est typiquement d'environ 200 nm. La fabrication d'un tel réseau nécessite une lithographie haute résolution et demeure donc relativement complexe à maîtriser.

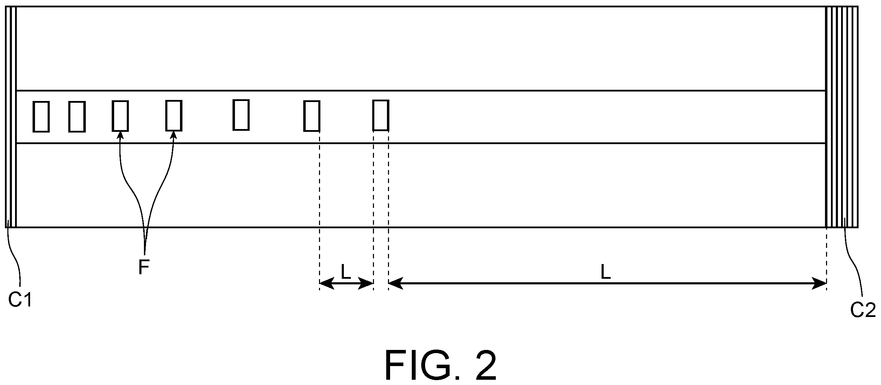

On connaît par ailleurs des lasers monomodes à structure de puits quantiques portée sur un substrat d'InP qui peuvent être fabriqués au moyen d'une lithographie de plus basse résolution. Comme représenté sur la figure 2, ces lasers exploitent pour structure de rétroaction des miroirs C1, C2 prenant la forme de facettes clivées d'un guide d'onde. Le fonctionnement monomode de ces lasers, dits DML pour « Discrète Mode Laser », est assuré au moyen de perturbations d'indice de réfraction réalisées par gravure de fentes F le long de l'arête du guide d'onde couplé à la structure de puits quantiques. Les fentes sont réalisées de manière à ce que la longueur L de tous les chemins optiques (longueurs des fentes, distances entre les fentes, distances entre les fentes et

$$L = (2.S + 1)\frac{\lambda_{m0}}{4.n_{eff}}$$

les miroirs) respecte , avec S un entier naturel (0, 1, 2...), $\lambda_{m0}$ la longueur d'onde dans le vide pour le mode du laser et $n_{eff}$ l'indice effecif au niveau des fentes. Ainsi, L est un nombre impair du quart d'onde du mode $\frac{\lambda_{m0}}{4.n_{eff}}$ . Un déphasage quart d'onde supplémentaire, analogue au segment S du laser DFB, peut être introduit lorsque nécessaire entre fentes ou entre fente et miroir.

Par comparaison avec un laser DFB fabriqué sur substrat InP, le laser DML présente une meilleure sélectivité ce qui se traduit par des largeurs de raie plus étroites et une sensibilité réduite aux réflexions extérieures. Le laser DML peut être fabriqué en utilisant une lithographie à basse résolution car les longueurs des fentes et les distances qui les séparent peuvent être des cavités d'ordre supérieur ( $3*\frac{\lambda_{m0}}{4.n_{eff}}$ ou $5*\frac{\lambda_{m0}}{4.n_{eff}}$ par exemple). En effet, la perte de rayonnement due à ces cavités d'ordre supérieur est moins préjudiciable à un laser DML qu'à un laser DFB, le laser DM nécessitant un nombre de fentes (généralement moins de 100) nettement inférieur au nombre de dents du réseau de Bragg d'un laser DFB (environ 2000 dents pour un réseau de 400 μm de long). Dans un tel laser DML, les fentes sont réalisées par lithographie et gravure dans le matériau InP au-dessus de la zone active. Le positionnement relatif d'une fente à une autre est ainsi très bien contrôlé. En revanche, il est impossible de contrôler exactement la position des miroirs C1, C2 relativement aux différentes fentes, car ces miroirs C1, C2 sont obtenus par clivage avec une précision de clivage d'au mieux 10 μm. Les incertitudes de positionnement des miroirs par rapport aux fentes peut se traduire par un non fonctionnement du laser.

Une solution pourrait consister à avoir recours, non pas à des facettes clivées, mais à la structure de rétroaction optique adoptée par les lasers DBR, à savoir des réflecteurs disposés dans le guide d'onde silicium de part et d'autre de la section de guide d'onde hybride.

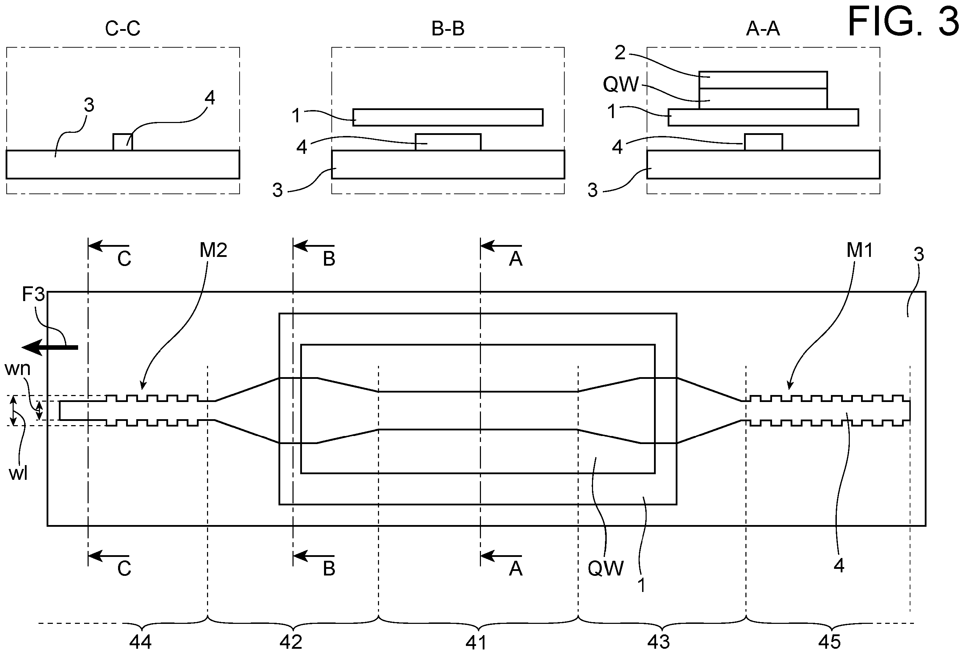

On a à cet effet représenté sur la figure 3 une vue de dessus simplifiée d'un laser DBR, cette vue de dessus étant accompagnée de trois coupes prises transversalement au sens de propagation de la lumière qui illustrent différentes régions du laser. Le laser DBR comprend un milieu amplificateur à hétérostructure III-V formé par exemple d'un empilement QW de puits quantiques pris en sandwich entre une couche d'InP dopée N 1 et une couche d'InP dopée P 2. Le laser comprend un guide d'onde optique en silicium, par exemple un guide d'onde en arête (« rib waveguide » en anglais) qui comprend un guide d'onde en ruban 3 (« slab waveguide » en anglais) surmontée d'une arête ou nervure 4 (« rib » en anglais). Le guide d'onde comprend une section de couplage 41 en regard d'une portion centrale du milieu amplificateur, deux sections de transition 42, 43 agencées de part et d'autre de la section de couplage 41, une section de propagation 44 optiquement couplée à l'une des sections de transition 42 et une section de réflexion 45 optiquement couplée à l'autre des sections de transition 43. Les sections de transition 42, 43 sont dimensionnées pour ne quasiment présenter aucune perte de transmission et aucune réflectivité.

Deux miroirs M1, M2 sont agencés en dehors du milieu amplificateur pour former la structure de rétroaction optique. Comme représenté sur la figure 3, il s'agit typiquement de réseaux de Bragg disposés de part et d'autre par rapport au milieu amplificateur à hétérostructure III-V, l'un M2 porté par la section de propagation 44, l'autre M1 porté par la section de réflexion 45. Le miroir M1 porté par la section de réflexion 45 présente une haute réflectivité (plus de 90%) tandis que le miroir M2 porté par la section de propagation 44 présente une faible réflectivité (inférieure à 50%). Le lumière issue de la cavité laser est ainsi couplée avec le guide en silicium et se propage en sortie selon la flèche F3 depuis la section de propagation 44.

Une telle solution à deux miroirs formés dans le guide d'onde silicium en dehors de la section de couplage avec le milieu amplificateur n'est toutefois pas satisfaisante pour les deux raisons suivantes.

Pour que les sections de transition 42, 43 ne présentent ni perte de transmission ni réflectivité, le guide d'onde en arête 3, 4 est pour cela épais avec une épaisseur cumulée du ruban 3 et de l'arête 4 typiquement supérieure ou égale à 400 nm, voire à 500 nm. Avec une épaisseur du ruban 3 de 300 nm, une épaisseur de l'arête 4 de 200nm et considérant la formation d'un réseau de Bragg par réduction de la largeur de l'arête 4 depuis wl=1500 nm vers wn=500 nm, le réseau de Bragg présente une période de 200 nm pour une longueur d'onde de 1310 nm. Comme pour le laser DFB, la fabrication d'un tel réseau nécessite une lithographie haute résolution et demeure donc relativement complexe à maîtriser.

Par ailleurs, le coefficient de réflexion introduit par chaque structure élémentaire du réseau de Bragg (micro-réflecteur) est faible de sorte que pour obtenir une haute réflectivité, il est nécessaire d'allonger le réseau. À titre d'exemple, il faut une longueur de 18 μm pour atteindre une réflectivité de 97%. Les miroirs M1, M2 viennent ainsi allonger la cavité laser (par rapport à un laser DML réalisé en InP, dans lequel les miroirs sont des facettes clivées disposées immédiatement en fin de zone active du laser) alors que l'on cherche d'une manière générale à disposer d'une cavité laser la plus courte possible pour que l'espacement entre chacun des modes de la cavité soit le plus large possible et ainsi assurer un fonctionnement du laser sans saut de mode.

Le document FR 3 061 961 A1 décrit un laser à semi-conducteur hybride évanescent III-V sur silicium laser dont la couche de guide d'ondes en Si est plus mince dans les sections des réflecteurs que dans une section de transition placée entre la section d'un réflecteur et une section de couplage faisant face à la région de gain. Elle décrit aussi une structure réfléchissante distribuée dans une section de couplage centrale.

## EXPOSÉ DE L'INVENTION

L'invention a pour objectif de proposer un dispositif laser monomode sur plateforme hybride III-V/Si qui puisse être fabriqué avec des outils de lithographie de basse résolution tout en assurant un fonctionnement de ce dispositif laser sans saut de mode (i.e. en proposant un laser dont la cavité est la plus courte possible au regard de la région active).

À cet effet, l'invention propose un dispositif laser comprenant :

- un milieu amplificateur à hétérostructure III-V ;
- un guide d'onde optique en silicium qui comporte une section de couplage en regard d'une portion centrale du milieu amplificateur, une section de propagation et une première section de transition agencée entre la section de couplage et la section de propagation ;
- une première et une deuxième structure réfléchissante permettant de former entre elles une cavité résonante de type Fabry-Pérot pour le milieu amplificateur.

La section de couplage comprend une région de perturbation d'indice de réfraction dotée de micro-réflecteurs conçus par réduction de l'épaisseur et/ou de la largeur de la section de couplage, les micro-réflecteurs présentant une longueur de $m*\frac{\lambda_{m0}}{4.n_{eff}}$ et étant séparés l'un de l'autre d'une distance supérieure à $n*\frac{\lambda_{m0}}{4.n_{eff}}$, avec m est un entier impair, n un entier, $\lambda_{m0}$ la longueur d'onde dans le vide et $n_{eff}$ l'indice efficace de la région de perturbation d'indice de réfraction.

La première structure réfléchissante est formée dans une section du guide d'onde qui présente une première épaisseur.

La deuxième structure réfléchissante est formée dans une section du guide d'onde qui présente la première épaisseur et qui est séparée de la section de couplage par une deuxième section de transition du guide d'onde, la deuxième section de transition présentant une deuxième épaisseur supérieure à la première épaisseur.

Certains aspects préférés mais non limitatifs de ce dispositif sont les suivants :

- La réflectivité de la deuxième structure réfléchissante est supérieure à la réflectivité de la première structure réfléchissante ;
- La réflectivité de la deuxième structure réfléchissante (Mr) est supérieure à 90% ;
- La réflectivité de la première structure réfléchissante est comprise entre 5% et 60% ;
- La deuxième structure réfléchissante est un réseau de Bragg ;
- La première épaisseur est comprise entre 50 et 300 nm et la deuxième épaisseur est supérieure d'au moins 100 nm, de préférence d'au moins 150 nm, à la première épaisseur ;
- La première structure réfléchissante est formée dans la première section de transition ;
- La première section de transition présente la deuxième épaisseur ;
- La première structure réfléchissante est un réseau de Bragg formé dans la section de couplage ;
- La première structure réfléchissante est un réseau de Bragg formé dans une section du guide d'onde intercalée entre la section de propagation et la première section de transition ;
- La guide d'onde est un guide d'onde doté d'une arête dirigée d'un côté opposé au milieu amplificateur;
- L'arête est localisée au niveau de la deuxième section de transition et, le cas échéant, de la première section de transition.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

La figure 1, déjà discutée précédemment, est un schéma d'un laser DFB sur plateforme hybride III-V/Si ;

La figure 2, déjà discutée précédemment, est un schéma d'un laser DML sur substrat InP ;

La figure 3, déjà discutée précédemment, est un schéma d'un laser DBR sur plateforme hybride III-V/Si ;

La figure 4 est une vue de dessus d'un laser selon un premier mode de réalisation possible de l'invention, cette vue de dessus étant accompagnée de trois coupes prises transversalement au sens de propagation de la lumière qui illustrent différentes régions du laser ;

La figure 5 est une vue en coupe longitudinale du laser de la figure 4 ;

La figure 6 est une vue de dessus d'un laser selon un deuxième mode de réalisation possible de l'invention, cette vue de dessus étant accompagnée de trois coupes prises transversalement au sens de propagation de la lumière qui illustrent différentes régions du laser ;

La figure 7 est une vue de dessus d'un laser selon un troisième mode de réalisation possible de l'invention, cette vue de dessus étant accompagnée de trois coupes prises transversalement au sens de propagation de la lumière qui illustrent différentes régions du laser.

## DESCRIPTION DÉTAILLÉE

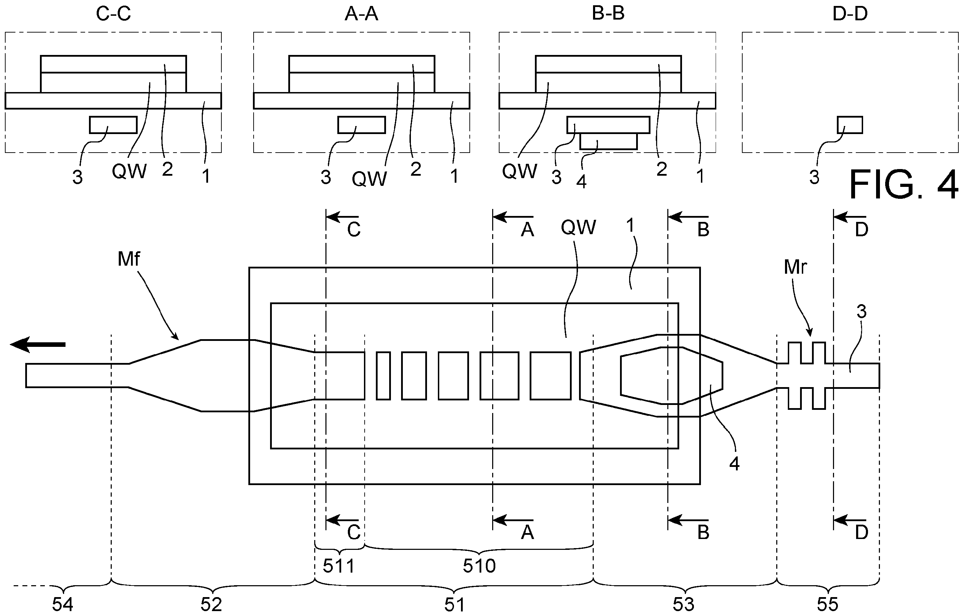

En référence aux figures 4 à 7, l'invention porte sur un dispositif laser comprenant un milieu amplificateur à hétérostructure III-V formé par exemple d'un empilement QW de puits quantiques pris en sandwich entre une couche d'InP dopée N 1 et une couche d'InP dopée P 2. Le laser comprend sous ce milieu amplificateur un guide d'onde optique en silicium, par exemple un guide d'onde en ruban 3 qui peut être surmontée, notamment localement, d'une arête ou nervure 4

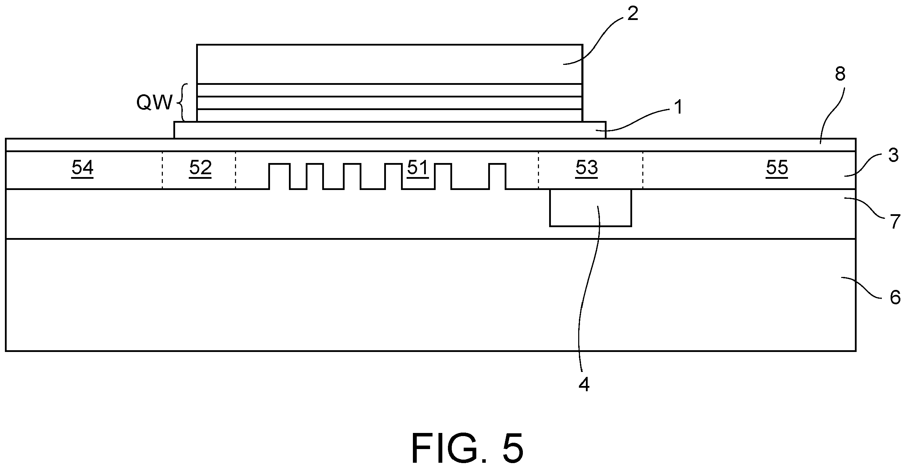

Comme illustré en figure 5, le guide d'onde en ruban 3 peut être formé dans la couche superficielle d'un substrat silicium-sur-isolant en étant ainsi séparée d'un substrat de silicium 6 par un couche d'isolant enterrée 7, typiquement en SiO2. Le guide d'onde est par ailleurs recouvert d'une couche d'isolant 8, typiquement en SiO2, qui permet notamment d'assurer le collage du milieu amplificateur. Comme représenté sur les vues en coupe transversales B-B des figures 4, 6 et 7, le guide d'onde en ruban 3 peut être localement surmontée d'une arête 4 dirigée du côté opposé au milieu amplificateur. Dans un mode de réalisation alternatif, cette arête localisée peut être dirigée vers le milieu amplificateur.

Le laser comprend par ailleurs une première et une deuxième structure réfléchissante Mf, Mr permettant de former entre elles une cavité résonante de type Fabry-Pérot pour le milieu amplificateur. Ces structures réfléchissantes seront présentées plus en détail ci-dessous mais on peut déjà relever que la réflectivité de la deuxième structure réfléchissante Mr peut être supérieure à la réflectivité de la première structure réfléchissante Mf. Une telle asymétrie de réflectivité permet de coupler préférentiellement la lumière d'un côté de la cavité laser. La réflectivité de la deuxième structure réfléchissante Mr est de préférence supérieure à 90%, tandis que la première structure réfléchissante Mf présente une réflectivité comprise de préférence entre 5% et 60%.

Le guide d'onde comprend une section de couplage 51, 61, 71 en regard d'une portion centrale du milieu amplificateur et une section de propagation 54, 64, 74 servant de port de sortie pour la lumière générée par le laser. La section de couplage 51, 61, 71 comprend une région de perturbation d'indice de réfraction 510, 610, 71 dotée de micro-réflecteurs conçus pour que la cavité résonnante fonctionne de manière monomode. Ces micro-réflecteurs sont constitués par réduction de l'épaisseur du guide d'onde silicium et/ou par réduction de la largeur du guide d'onde silicium. On en compte entre 10 et 200. Sur les figures, ces micro-réflecteurs sont représentés par des fentes dans le guide d'onde silicium venant en réduire l'épaisseur. Ces micro-réflecteurs, par exemple similaires aux fentes présentes dans un laser DML, sont réalisés comme indiqué précédemment de manière à ce que les micro-réflecteurs présentent une longueur de $m * \dfrac{\lambda_{m0}}{4.n_{eff}}$ et soient séparés l'un de l'autre d'une distance supérieure à $n * \dfrac{\lambda_{m0}}{4.n_{eff}}$, avec m est un entier impair, n un entier, $\lambda_{m0}$ la longueur d'onde dans le vide et $n_{eff}$ l'indice effecif de la région de perturbation d'indice de réfraction. Un déphasage quart d'onde supplémentaire, analogue au segment S du laser DFB, peut être introduit lorsque nécessaire entre micro-réflecteurs ou entre micro-réflecteur et miroir. La position des micro-réflecteurs peut par exemple être déterminée selon l'approche présentée dans l'article de S. O'Brien et al., "Spectral manipulation in Fabry-Perot lasers: perturbative inverse scattering approach," J. Opt. Soc. Am. B 23, 1046-1056 (2006). La section de couplage 51, 51 peut comprendre une ou plusieurs régions additionnelles 511, 611 d'un côté ou de l'autre de la région de perturbation d'indice de réfraction 510, 610.

Le guide d'onde comprend par ailleurs une première section de transition 52, 62, 72 agencée entre la section de propagation 54, 64, 74 et la section de couplage 51, 61, 71. Il comprend également une section de réflexion dite de haute réflectivité 55, 65, 75 et une deuxième section de transition 53, 63, 73 agencée entre la section de couplage 51, 61, 71 et la section de haute réflectivité 55, 65, 75.

Selon l'invention, la première structure réfléchissante Mf est formée dans une section du guide d'onde qui présente une première épaisseur et la deuxième structure réfléchissante Mr est formée dans une section du guide d'onde qui présente la première épaisseur et qui est séparée de la section de couplage 51, 61, 71 par la deuxième section de transition 53, 63, 73 du guide d'onde, la deuxième section de transition présentant une deuxième épaisseur supérieure à la première épaisseur. La première épaisseur peut être comprise entre 50 et 300 nm et la deuxième épaisseur est supérieure d'au moins 100 nm, de préférence d'au moins 150 nm, à la première épaisseur.

Dans le cadre du premier mode de réalisation illustré sur les figures 4 et 5, la première section de transition 52 forme la première structure réfléchissante Mf de la cavité résonante.

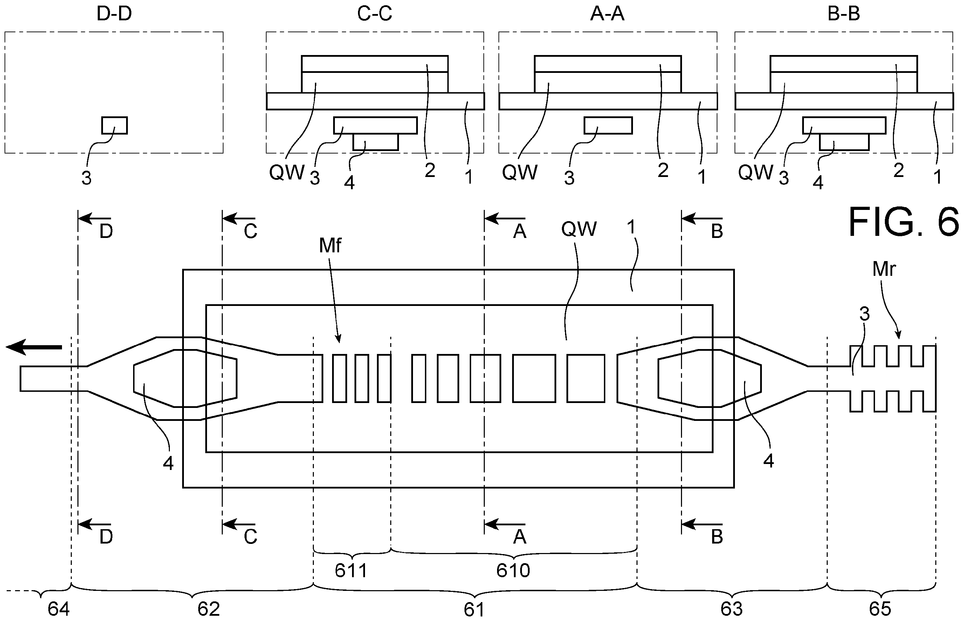

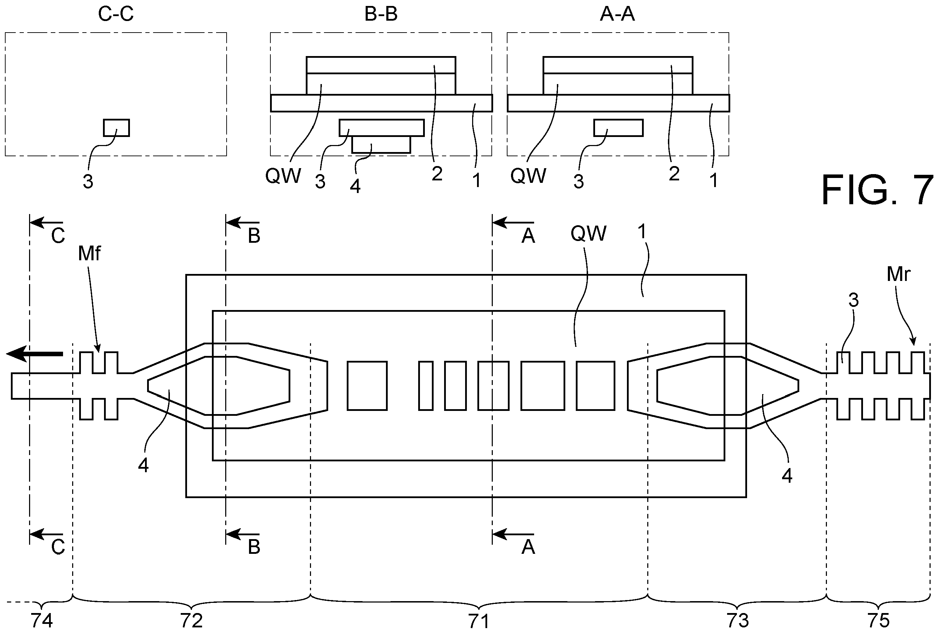

Dans le cadre du second et du troisième mode de réalisation, la première structure réfléchissante Mf de la cavité résonante est un réseau de Bragg porté par le guide d'onde à l'intérieur (figure 6) ou à l'extérieur (figure 7) de la section de couplage 61, 71. La première section de transition 62, 72 présente alors la deuxième épaisseur.

Dans le deuxième mode de réalisation représenté sur la figure 6, le réseau de Bragg formant la première structure réfléchissante Mf est ainsi porté par la section de couplage 61 à l'extérieur de la région de perturbation d'indice de réfraction 610, c'est-à-dire par une région additionnelle 611 de la section de couplage agencée entre la région de perturbation d'indice de réfraction 610 et la première section de transition 62.

Dans le troisième mode de réalisation représenté sur la figure 7, le réseau de Bragg formant la première structure réfléchissante Mf est quant à lui porté par une section dite de faible réflectivité 76 intercalé entre la première section de transition 72 et la section de propagation 74.

Dans ces modes de réalisation, la deuxième structure réfléchissante Mr peut quant à elle être formée par un réseau de Bragg porté par la section de haute réflectivité 55, 65, 75 du guide d'onde, à l'extérieur de la section de couplage 51, 61, 71 du côté opposé à la première structure réfléchissante Mf (alternativement le réseau de Bragg de haute réflectivité peut être porté à l'intérieur de la section de couplage). Le guide d'onde silicium peut présenter une faible épaisseur au niveau du réseau de Bragg formant la deuxième structure réfléchissante Mr, ainsi que le cas échéant au niveau du réseau de Bragg formant la deuxième structure réfléchissante Mr. Il s'avère dès lors possible de réaliser des réseaux de Bragg dont la période est plus importante que dans l'état de l'art (typiquement plus de 220 nm, par exemple de 227 nm avec une épaisseur du guide d'onde de 220nm et une longueur d'onde de 1310 nm) ce qui permet de relâcher les contraintes de fabrication, tout en présentant des forces de réaction élevées ce qui permet de réduire la longueur du réseau (toujours selon le même exemple, un réseau de 10 μm de long permet d'atteindre une réflectivité de 97%).

Également, au contraire des lasers DML connus pour lesquels la position des facettes est définie par clivage, les deux structures réfléchissantes de l'invention peuvent être définies par lithographie ce qui permet de mieux contrôler le positionnement de ces structures vis-à-vis des micro-réflecteurs dans la section de couplage. Par ailleurs, la première structure réfléchissante du premier mode de réalisation présente une longueur réduite par rapport à un réseau de Bragg conventionnel ce qui permet de concevoir une cavité laser de longueur encore plus réduite.

Alors que des guides d'onde silicium relativement fins (100 nm à 300 nm typiquement) sont classiquement utilisés pour les composants photoniques silicium (de guidage ou de modulation par exemple), il est connu que les lasers hybrides III-V/Silicium nécessitent des épaisseurs relativement importantes (500 nm typiquement) pour concevoir des sections de transition adiabatiques (i.e. sans pertes). La largeur du guide d'onde est également réduite/augmentée dans ces sections de transition. Comme illustré par les coupes B-B sur les figures 4, 6 et 7, le guide d'onde présente ainsi dans la deuxième section de transition 53, 63, 73 (et dans la première section de transition 62, 72 dans le cadre des deuxième et troisième mode de réalisation) une largeur qui est par exemple de 3 μm (comparable à la largeur de l'empilement couche InP 2/ puits quantiques QW) et une épaisseur qui est par exemple de 500 nm.

Afin de former la première structure réfléchissante au moyen de la première section de transition 52 dans le cadre du premier mode de réalisation, on peut adopter pour celle-ci une épaisseur et/ou une largeur inférieure à l'épaisseur et/ou la largeur de la deuxième section de transition 53. Ainsi l'épaisseur de la première section de transition 52 peut être comprise entre 50 et 300 nm et/ou sa largeur peut être comprise entre 300 nm et 1 μm. Comme représenté en figure 5, une différence d'épaisseur entre la première section de transition 52 et la deuxième section de transition 53 peut être obtenue par une surépaisseur de silicium 4 réalisée dans la couche d'isolant enterrée 7 localement au niveau de la deuxième section de transition 53.

De la même manière, dans le cadre du deuxième et du troisième mode de réalisation, le réseau de Bragg formant la première structure réfléchissante est porté par une section du guide d'onde qui présente une épaisseur et/ou une largeur inférieure à l'épaisseur et/ou la largeur des sections de transition 62, 72 et 63, 73 et notamment une épaisseur comprise entre 50 et 300 nm et/ou une largeur comprise entre 300 nm et 1 μm. Une différence d'épaisseur peut notamment être obtenue au moyen d'une surépaisseur de silicium 4 réalisée dans la couche d'isolant enterrée 7 localement au niveau de la première section de transition 62, 72 et localement au niveau de la deuxième section de transition 63, 73.

**Revendications**

1. Dispositif laser comprenant :

   - un milieu amplificateur à hétérostructure III-V (1, QW, 2) ;
   - un guide d'onde optique en silicium (3, 4) qui comporte une section de couplage (51, 61, 71) en regard d'une portion centrale du milieu amplificateur, une section de propagation (54, 64, 74) et une première section de transition (52, 62, 72) agencée entre la section de couplage (51, 61, 71) et la section de propagation (54, 64, 74),
   - une première et une deuxième structure réfléchissante (Mf, Mr) permettant de former entre elles une cavité résonante de type Fabry-Pérot pour le milieu amplificateur;

dans lequel la section de couplage (51, 61, 71) comprend une région de perturbation d'indice de réfraction (510, 610, 71) dotée de micro-réflecteurs conçus par réduction de l'épaisseur et/ou de la largeur de la section de couplage, les micro-réflecteurs présentant une longueur de $m*\frac{\lambda_{m0}}{4.n_{eff}}$ et étant séparés l'un de l'autre d'une distance supérieure à $n*\frac{\lambda_{m0}}{4.n_{eff}}$, avec m est un entier impair, n un entier, $\lambda_{m0}$ la longueur d'onde dans le vide et $n_{eff}$ l'indice effectif de la région de perturbation d'indice de réfraction ; en ce que la première structure réfléchissante (Mf) est formée dans une section du guide d'onde qui présente une première épaisseur ; et en ce que la deuxième structure réfléchissante (Mr) est formée dans une section du guide d'onde (55, 65, 75) qui présente la première épaisseur et qui est séparée de la section de couplage (51, 61, 71) par une deuxième section de transition (53, 63, 73) du guide d'onde, la deuxième section de transition (53, 63, 73) présentant une deuxième épaisseur supérieure à la première épaisseur.

2. Dispositif laser selon la revendication 1, dans lequel la réflectivité de la deuxième structure réfléchissante (Mf) est supérieure à la réflectivité de la première structure réfléchissante (Mr).

3. Dispositif laser selon la revendication 2, dans lequel la réflectivité de la deuxième structure réfléchissante (Mr) est supérieure à 90%.

4. Dispositif laser selon l'une des revendications 2 et 3, dans lequel la réflectivité de la première structure réfléchissante (Mf) est comprise entre 5% et 60%.

5. Dispositif laser selon l'une des revendications 1 à 4, dans lequel la deuxième structure réfléchissante (Mr) est un réseau de Bragg.

6. Dispositif laser selon l'une des revendications 1 à 5, dans lequel la première épaisseur est comprise entre 50 et 300 nm et dans lequel la deuxième épaisseur est supérieure d'au moins 100 nm, de préférence d'au moins 150 nm, à la première épaisseur.

7. Dispositif laser selon l'une des revendications 1 à 6, dans lequel la première structure réfléchissante (Mf) est formée dans la première section de transition (52).

8. Dispositif laser selon l'une des revendications 1 à 6, dans lequel la première section de transition (62, 72) présente la deuxième épaisseur.

9. Dispositif laser selon la revendication 8, dans lequel la première structure réfléchissante est un réseau de Bragg formé dans la section de couplage (61).

10. Dispositif laser selon la revendication 8, dans lequel la première structure réfléchissante est un réseau de Bragg formé dans une section du guide d'onde (76) intercalée entre la section de propagation (74) et la première section de transition (72).

11. Dispositif laser selon l'une des revendications 1 à 10, dans lequel le guide d'onde est un guide d'onde doté d'une arête (4) dirigée d'un côté opposé au milieu amplificateur.

12. Dispositif laser selon la revendication 11 prise en combinaison avec la revendication 7, dans lequel l'arête est localisée au niveau de la deuxième section de transition (53).

13. Dispositif laser selon la revendication 11 prise en combinaison avec l'une des revendications 8 à 10, dans lequel l'arête est localisée au niveau de la première section de transition (62, 72) et au niveau de la deuxième section de transition (63, 73).

**Patentansprüche**

1. Laservorrichtung, umfassend:

   - ein verstärkendes Medium mit III-V-Heterostruktur (1, QW, 2);
   - einen optischen Wellenleiter aus Silizium (3, 4), der einen Kopplungsabschnitt (51, 61, 71) gegenüber einem zentralen Teil des verstärkenden Mediums beinhaltet, einen Ausbreitungsabschnitt (54, 64, 74) und einen ersten Übergangsabschnitt (52, 62, 72), der zwischen dem Kopplungsabschnitt (51, 61, 71) und dem Ausbreitungsabschnitt (54, 64, 74) angeordnet ist,
   - eine erste und eine zweite reflektierende Struktur (Mf, Mr), die zwischen sich die Bildung eines Resonanzhohlraums vom Typ Fabry-Pérot für das verstärkende Medium ermöglichen;

   wobei der Kopplungsabschnitt (51, 61, 71) einen Brechungsindex-Störbereich (510, 610, 71) umfasst, der mit Mikroreflektoren ausgestattet ist, die durch Verringerung der Dicke und/oder der Breite des Kopplungsabschnitts konstruiert sind, wobei die Mikroreflektoren eine Länge von $m*\frac{\lambda_{mo}}{4.n_{eff}}$ aufweisen und um einen Abstand größer als $n * \frac{\lambda_{mo}}{4.n_{eff}}$ voneinander getrennt sind, wobei m eine ungerade ganze Zahl, n eine ganze Zahl, $\lambda_{mo}$ die Wellenlänge im Vakuum und $n_{eff}$ der effektive Index des Brechungsindex-Störbereichs ist;

wobei die erste reflektierende Struktur (Mf) in einem Abschnitt des Wellenleiters gebildet ist, der eine erste Dicke aufweist; und

wobei die zweite reflektierende Struktur (Mr) in einem Abschnitt des Wellenleiters (55, 65, 75) gebildet ist, der die erste Dicke aufweist und vom Kopplungsabschnitt (51, 61, 71) durch einen zweiten Übergangsabschnitt (53, 63, 73) des Wellenleiters getrennt ist, wobei der zweite Übergangsabschnitt (53, 63, 73) eine zweite Dicke aufweist, die größer ist als die erste Dicke.

2. Laservorrichtung nach Anspruch 1, wobei das Reflexionsvermögen der zweiten reflektierenden Struktur (Mf) größer ist als das Reflexionsvermögen der ersten reflektierenden Struktur (Mr).

3. Laservorrichtung nach Anspruch 2, wobei das Reflexionsvermögen der zweiten reflektierenden Struktur (Mr) größer als 90 % ist.

4. Laservorrichtung nach einem der Ansprüche 2 und 3, wobei das Reflexionsvermögen der ersten reflektierenden Struktur (Mf) zwischen 5 % und 60 % liegt.

5. Laservorrichtung nach einem der Ansprüche 1 bis 4, wobei die zweite reflektierende Struktur (Mr) ein Bragg-Spiegel ist.

6. Laservorrichtung nach einem der Ansprüche 1 bis 5, wobei die erste Dicke zwischen 50 und 300 nm liegt und wobei die zweite Dicke um mindestens 100 nm größer ist, vorzugsweise um mindestens 150 nm, als die erste Dicke.

7. Laservorrichtung nach einem der Ansprüche 1 bis 6, wobei die erste reflektierende Struktur (Mf) im ersten Übergangsabschnitt (52) gebildet ist.

8. Laservorrichtung nach einem der Ansprüche 1 bis 6, wobei der erste Übergangsabschnitt (62, 72) die zweite Dicke aufweist.

9. Laservorrichtung nach Anspruch 8, wobei die erste reflektierende Struktur ein im Kopplungsabschnitt (61) gebildeter Bragg-Spiegel ist.

10. Laservorrichtung nach Anspruch 8, wobei die erste reflektierende Struktur ein Bragg-Spiegel ist, der in einem Abschnitt des Wellenleiters (76) gebildet ist, der zwischen dem Ausbreitungsabschnitt (74) und dem ersten Übergangsabschnitt (72) eingefügt ist.

11. Laservorrichtung nach einem der Ansprüche 1 bis 10, wobei der Wellenleiter ein mit einer Kante (4) ausgestatteter Wellenleiter ist, die auf eine dem verstärkenden Medium gegenüberliegende Seite gerichtet ist.

12. Laservorrichtung nach Anspruch 11 in Kombination mit Anspruch 7, wobei die Kante im Bereich des zweiten Übergangsabschnitts (53) lokalisiert ist.

13. Laservorrichtung nach Anspruch 11 in Kombination mit einem der Ansprüche 8 bis 10, wobei die Kante im Bereich des ersten Übergangsabschnitts (62, 72) und im Bereich des zweiten Übergangsabschnitts (63, 73) lokalisiert ist.

**Claims**

1. Laser device comprising:

- a III-V heterostructure amplifying medium (1, QW, 2);
- a silicon optical waveguide (3, 4) which includes a coupling section (51, 61, 71) facing a central portion of the amplifying medium, a propagation section (54, 64, 74) and a first transition section (52, 62, 72) arranged between the coupling section (51, 61, 71) and the propagation section (54, 64, 74);
- a first and a second reflective structure (Mf, Mr) allowing a Fabry-Perot type resonant cavity to be formed between them for the amplifying medium;

wherein the coupling section (51, 61, 71) comprises a refractive index disturbance region (510, 610, 71) provided with micro-reflectors designed by reducing the thickness and/or the width of the coupling section, the micro-reflectors having a length of $m * \frac{\lambda_{mo}}{4.n_{eff}}$ and being separated from one another by a distance greater than $n * \frac{\lambda_{mo}}{4.n_{eff}}$, where m is an odd integer, n an integer, $\lambda_{m0}$ the wavelength in vacuum and $n_{eff}$ the effective index of the refractive index disturbance region;

wherein the first reflective structure (Mf) is formed in a section of the waveguide which has a first thickness; and

wherein the second reflective structure (Mr) is formed in a section of the waveguide (55, 65, 75) which has the first thickness and which is separated from the coupling section (51, 61, 71) by a second transition section (53, 63, 73) of the waveguide, the second transition section (53, 63, 73) having a second thickness greater than the first thickness.

2. Laser device according to claim 1, wherein the reflectivity of the second reflective structure (Mf) is greater than the reflectivity of the first reflective structure (Mr).

3. Laser device according to claim 2, wherein the reflectivity of the second reflective structure (Mr) is greater than 90%.

4. Laser device according to one of claims 2 and 3, wherein the reflectivity of the first reflective structure (Mf) is between 5% and 60%.

5. Laser device according to one of claims 1 to 4, wherein the second reflective structure (Mr) is a Bragg grating.

6. Laser device according to one of claims 1 to 5, wherein the first thickness is between 50 and 300 nm and wherein the second thickness is greater by at least 100 nm, preferably at least 150 nm, than the first thickness.

7. Laser device according to one of claims 1 to 6, wherein the first reflective structure (Mf) is formed in the first transition section (52).

8. Laser device according to one of claims 1 to 6, wherein the first transition section (62, 72) has the second thickness.

9. Laser device according to claim 8, wherein the first reflective structure is a Bragg grating formed in the coupling section (61).

10. Laser device according to claim 8, wherein the first reflective structure is a Bragg grating formed in a section of the waveguide (76) inserted between the propagation section (74) and the first transition section (72).

11. Laser device according to one of claims 1 to 10, wherein the waveguide is a waveguide provided with a rib (4) directed away from the amplifying medium.

12. Laser device according to claim 11 taken in combination with claim 7, wherein the rib is located at the second transition section (53).

13. Laser device according to claim 11 taken in combination with one of claims 8 to 10, wherein the rib is located at the first transition section (62, 72) and at the second transition section (63, 73).

FIG. 1

FIG. 2

EP 3 949 042 B1

FIG. 3

FIG. 4

EP 3 949 042 B1

FIG. 5

# FIG. 6

FIG. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3061961 A1

**Littérature non-brevet citée dans la description**

- **S. O'BRIEN et al.** Spectral manipulation in Fabry-Perot lasers: perturbative inverse scattering approach. *J. Opt. Soc. Am.,* 2006, vol. 23, 1046-1056